# EUROPEAN PATENT APPLICATION

(11) **EP 4 543 171 A1**
(43) Date of publication of application: **23.04.2025**
(21) Application number: 23461671.2
(22) Date of filing: 20.10.2023
(51) Int. Cl.: H10K 30/85, H10K 30/86, H10K 71/10, H10K 85/50

(54) **A METHOD FOR PRODUCING A COMPACT AND PIN-HOLE FREE PEROVSKITE FILM FOR PHOTOVOLTAICS**

(71) Applicant: Saule S.A., 54-427 Wroclaw (PL)
(72) Inventor: PRZYPIS, Lukasz, 44-186 Gieraltowice (PL); ALMOSNI, Samy, 53-203 Wroclaw (PL); OZ, Senol, 54-427 Wroclaw (PL); WOJCIECHOWSKI, Konrad, 52-016 Wroclaw (PL); KLAB, Tomasz, 95-040 Koluszki (PL); JANICKA, Patrycja, 51-354 Wroclaw (PL); RYCEK, Kinga, 50-521 Wroclaw (PL)
(74) Representative: Kancelaria Eupatent.pl Sp. z.o.o

(57) **Abstract**

The object of the invention is a method for producing a photoactive film comprising a substrate (111), a photoactive layer (113) with a perovskite material and a functional layer (112) between the substrate and the photoactive layer.

## Description

### TECHNICAL FIELD

The present disclosure relates to the field of thin film photovoltaics, specifically addressing the problem of fabricating compact and pin-hole free perovskite layers used as absorbers in photovoltaic solar cells.

### BACKGROUND

In recent years, perovskite photovoltaic technology has emerged as a promising approach for achieving highly efficient and cost-effective solar energy conversion. Perovskite solar cells have gained significant attention due to their exceptional characteristics, including high power conversion efficiency, low manufacturing costs and tunable optoelectronic properties. These characteristics of perovskite solar cells along with the possibility of fabricating flexible photovoltaic devices using solution processing techniques, have provoked tremendous interest in their applications across a variety of fields, including building-integrated photovoltaics, renewable energy infrastructure, portable electronics and IoT devices.

However, despite the remarkable progress, challenges remain in the large-scale industrial production of perovskite solar cells. One critical challenge lies in the fabrication of high-quality perovskite films using scalable deposition techniques. Achieving uniform and reproducible film formation on a large scale remains a serious hurdle, affecting the overall performance, stability, and commercial viability of perovskite solar cells.

One of the problems, which has been the subject of extensive research and development efforts, lies in the precise control of the process of nucleation and growth of perovskite crystals to achieve uniform coverage over large areas, thereby maximizing light absorption and minimizing charge carrier losses. In conventional fabrication techniques, such as spin coating, the slow evaporation of solvents often results in a limited degree of supersaturation and leads to low densities of heterogeneous nuclei, causing an imbalance between nucleation and crystal growth and the creation of large dendritic perovskite structures, which have a detrimental effect on the performance of the devices. To achieve high-efficiency photovoltaic devices, one crucial aspect is the fabrication of high-quality, dense and uniform perovskite absorber layers that are free from defects, pinholes, and other imperfections, which can lead to electron-hole recombination and reduced device performance.

Several approaches have been employed in the past to address the issues mentioned above. One of them relates to perovskite precursor engineering and using sacrificial anions for perovskite deposition in order to modulate the film formation process. Wang et al. in a scientific article "Achieving Efficient and Stable Perovskite Solar Cells in Ambient Air Through Non-Halide Engineering" (Adv. Energy Mater. 2021, 11, 2102169) describes the use of sacrificial anions for perovskite deposition to obtain compact and uniform perovskite films. However, methods concerning precursor engineering require using complex precursor solutions and leave possibilities of unwanted ligands being retained in the final film.

Another known approach relates to quenching techniques. Antisolvent quenching involves dripping an orthogonal solvent onto the perovskite wet film, enhancing the evaporation of high boiling point solvents, leading to the rapid formation of the perovskite intermediate phase and obtaining dense perovskite films. Gas quenching technique, on the other hand, includes blowing gas onto the perovskite wet film in order to expedite evaporation of solvents. It facilitates nucleation, which results in a high density of perovskite nuclei. However, quenching techniques present certain drawbacks. As described by Congcong Wu et al. in an article "Volatile solution: the way toward scalable fabrication of perovskite solar cells?" (Matter 4, 775-793, published by Elsevier Inc., doi.org/10.1016/j.matt.2020.12.025), the antisolvent quenching exhibits several challenges when applied to a continuous industrial production line, due to a small processing window. Antisolvent post-treatment needs to be precisely controlled, otherwise it would be ineffective, if the timing is missed. Additionally, parameters, such as: solvent volume, pump pressure and a flow rate need precise adjustments. Moreover, antisolvent quenching results in poor uniformity of films and poor repeatability. Gas quenching requires precise control over the timing and the amount of gas used in the process as well as a blow gas flow rate. The overall production costs are increased due to the necessity of using inert gases. Overall, quenching methods used in film formation processes are generally not applicable and not preferred in large-scale industrial production.

Chang Liu et al. in an article "Understanding of perovskite crystal growth and film formation in scalable deposition processes" (Royal Society of Chemistry, DOI: 10.1039/c9cs00711c) describe a vacuum-assisted solution process featuring in rapid and well-controlled removal of solvents by placing a semi-wet perovskite film in a vacuum chamber. It facilitates the supersaturation and promotes fast perovskite intermediate phase formation, therefore making it possible to obtain homogeneous perovskite films. This method, however, presents certain drawbacks, such as difficulty in large-area continuous preparation due to the necessity of creating a vacuum environment, making it not feasible for applying in mass industrial production.

Another known approach is known as hot casting. It involves increasing the substrate temperature during the coating step to enhance the evaporation of high boiling point solvents, resulting in rapid perovskite intermediate phase formation. However, this approach increases the energy cost of the process and may not be suitable for all deposition methods.

The above-mentioned methods have made significant contributions to the field of perovskite film fabrication. However, they suffer from certain limitations and challenges creating issues for large scale industrial applicability, that are preventing perovskite photovoltaic technology from unlocking its full potential and ensuring its successful integration into mainstream solar energy conversion systems. There is still a need for improved methods that ensure uniform and dense perovskite films with optimized compositions, stability, and efficiency.

### SUMMARY OF THE INVENTION

Therefore, it would be desirable to develop a scalable method for producing a photoactive film having a compact and pin-hole free perovskite layer with uniform surface coverage using less complex fabrication processes. The present invention addresses the challenges described above, allowing to fabricate high-quality perovskite films suitable for efficient perovskite solar cells. The significance of this invention lies in its potential to revolutionize the field of perovskite photovoltaics by enabling the cost-effective and scalable production of high-performance solar cells. By overcoming the limitations of existing fabrication techniques, this invention facilitates commercial applications of perovskite solar cells, contributing to the global transition towards sustainable energy sources.

In one aspect, the invention relates to a method for producing a photoactive film having a substrate, a photoactive layer with a perovskite material and a functional layer between the substrate and the photoactive layer. The method comprises forming the functional layer by depositing a functional layer solution on the substrate and then forming the photoactive layer of perovskite material ABX3 by depositing a perovskite material solution on the functional layer. The perovskite material solution comprises A, B and X perovskite precursors, and a solvent system. The functional layer solution comprises a phase transfer catalyst, wherein the phase transfer catalyst is selected so as to catalyze the reaction of forming ABX3 from A, B and X perovskite precursors.

The perovskite material solution comprising A, B and X perovskite precursors together with the solvent system allows to form the photoactive layer in a single deposition step using one of the common scalable solution deposition methods. This contrasts with multi-step perovskite deposition processes, which require at least two sequential steps to form a photoactive film. A single deposition step provides simplicity, cost-effectiveness, scalability potential and availability for high-speed fabrication. A process involving two or more deposition steps adds complexity, as each precursor solution and deposition conditions need to be carefully optimized. Also, multiple precursor solutions may increase material costs compared to the one-step method.

The phase transfer catalyst (PTC) is present in the functional layer solution, wherein said phase transfer catalyst is selected so as to catalyze the reaction of forming the perovskite material ABX3 of the photoactive layer. The phase transfer catalyst facilitates perovskite nucleation, provides stable perovskite intermediate phase and promotes controlled perovskite crystallization, which in turn results in a high-quality and pin-hole free perovskite photoactive layer, where the amount of defects is reduced. The inventors have found that the phase transfer catalyst allows to migrate reactive ions present in the functional layer or in the substrate towards the perovskite material solution being deposited on top of the functional layer or on top of the substrate. These migrating ions interact with perovskite precursors, affecting the perovskite nucleation rate, enabling bottom-to-top perovskite crystallization and providing a wider processing window for the consecutive formation of the photovoltaic device, due to the stable perovskite intermediate phase.

Preferably, the phase transfer catalyst is selected from the group of quaternary salts with a general formula: 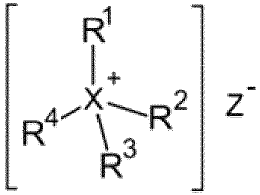 wherein
R¹, R², R³, R⁴ each independently represents an alkyl group, a hetero alkyl group, an aryl group, a hetero aryl group, an alkylaryl group, a hetero alkylaryl group, wherein heteroatoms comprise at least one of N, O, S; X represents nitrogen or phosphorous;
Z represents
an inorganic anion selected from the group of halides, triflates, hydroxide (OH⁻), nitrate (NO₃⁻), sulfate (SO₄²⁻), phosphate (PO₄³⁻), carbonate (CO₃²⁻), bicarbonate (HCO₃⁻), peroxide (O₂²⁻), cyanide (CN⁻), thiocyanate (SCN⁻), sulfite (SO₃²⁻), thiosulfate (S₂O₃²⁻), hypochlorite (ClO⁻), chlorate (ClO₃⁻), perchlorate (ClO₄⁻), permanganate (MnO₄⁻), chromate (CrO₄²⁻), dichromate (Cr_2O₇²⁻), azide (N₃⁻), hydrogensulfate (HSO₄⁻), hydrogenphosphate (HPO₄²⁻), dihydrogenphosphate (H₂PO₄⁻), or
an organic anion selected from the group of carboxylates (C₁ - Cs) including dicarboxylates (C₂ - C₆), benzoate (C₆H₅COO⁻) or lactate (C₃H₅O₃⁻).

The phase transfer catalyst may be selected from the group of monoalkylammonium salts, dialkylammonium salts, trialkylammonium salts or tetraalkylammonium salts.

Preferably, the phase transfer catalyst is selected from the group of tetraalkylammonium salts, such as, but not limited to tetramethylammonium (TMA) salts, tetraethylammonium salts, tetrapropylammonium salts and tetrabutylammonium salts. The non-limiting examples of the phase transfer catalysts are: tetramethylammonium acetate (TMAAc), tetramethylammonium bromide (TMABr), tetramethylammonium chloride (TMACl), tetramethylammonium iodide (TMAI), tetrafluoroborate (TMABF4), tetraethylammonium iodide (TEAI), tetrapropylammonium formate, tetrabutylammonium chloride or (2-hydroxyethyl)trimethylammonium chloride.

Preferably, the phase transfer catalyst is selected from the group of polyethylene glycol (PEG) materials, where each PEG material is defined by its molecular weight. Preferably, the phase transfer catalyst is selected from PEG materials having molecular weights in the range of 400 g/mol to 2000000 g/mol, which corresponds to PEG 400 and PEG 2000000 respectively.

The above materials are especially suitable to effectively work as phase transfer catalysts according to the present disclosure. Firstly, they are not miscible or soluble in the perovskite material solution. Miscibility or solubility of a phase transfer catalyst in a solution limits its ability to provide the desired functionality, as it would not be able to migrate ions between different phases. Additionally, the materials selected from the abovementioned groups provide a certain catalysis reaction rate which is adequate to the perovskite material crystallization rate and, in other words, the time needed for the perovskite material to crystalize. The ratio of the PTC catalysis reaction time with regards to the perovskite crystallization time is aligned and optimized, so that said beneficial effect as described above is possible to obtain.

Preferably, the functional layer solution comprises the phase transfer catalyst in a concentration between 0.1 mg/mL and 100 mg/mL. For the phase transfer catalyst selected from the group of quaternary salts, such as tetraalkylammonium salts,, the concentration in the functional layer solution is preferably within a range of 0.1 mg/mL and 100 mg/mL. Preferably the abovementioned concentration of the phase transfer catalyst in the functional layer solution is within a range of 0.1 mg/mL and 10 mg/mL. For the phase transfer catalyst selected from the group of polyethylene glycol (PEG) materials, the concentration in the functional layer solution is preferably within a range of 0.1 mg/mL and 100 mg/mL.

The phase transfer catalyst provided within given concentration range in the functional layer solution provides the desired effect of facilitating the migration of at least one reactant from one phase to another. The abovementioned effect is achievable for wide range of concentrations of the phase transfer catalyst, within the specified range. For the phase transfer catalyst selected from the group of quaternary salts, such as tetraalkylammonium salts, the concentration in the functional layer solution is dependent on the length of the carbon chain. For the phase transfer catalyst selected from the group of polyethylene glycol (PEG) materials the concentration in the functional layer solution depends on the molecular weight, wherein lower concentration is needed for higher molecular weights and higher concentration is needed for lower molecular weights.

Preferably, the functional layer comprises a charge transporting material, which allows to improve performance of a photovoltaic device, as the charge transporting material plays a crucial role in facilitating the efficient extraction and transport of charge carriers generated within the photoactive layer due to charge selectivity.

Preferably, the functional layer comprises the charge transporting material, where the charge transporting material is an electron transporting material selected from the group consisting of SrO2, SnO2, TiO2, ZnO, ZnSnO4, ZnSnS4, BaSnO4 and PCBM. Other electron transporting materials may also be used in the functional layer, such as fullerene or fullerene derivatives, as well as perylene or perylene derivatives.

The presence of the electron transporting material allows to improve performance of photovoltaic devices by providing increased electron extraction from the photoactive layer and decreasing charge recombination. The above materials, serving as the electron transporting materials, provide increased electron selectivity and effective electron transport through the thickness of the functional layer towards an electrode material and further reduction of recombination losses, due to appropriate interfacial energy alignment with the perovskite material. Moreover, the abovementioned electron transporting materials provide additional technical effect when combined with the phase transfer catalyst, as the reactive ions present therein are suitable for being migrated by the phase transfer catalyst towards the perovskite material solution deposited on top of the functional layer and further interact with perovskite precursors, which results in rapid perovskite nucleation, stable perovskite intermediate phase and controlled perovskite crystallization. This further results in fabrication of high-quality perovskite films.

Preferably, the functional layer comprises the charge transporting material, where the charge transporting material is a hole transporting material selected from the group consisting of: CuSCN, CuO, Cu2O, CuI, CuBr, WO3, MoO3, CoO, CoO2, PTAA (Poly[bis(4-phenyl)(2,4,6-trimethylphenyl)amine), PEDOT:PSS (poly(3,4-ethylenedioxythiophene) polystyrene sulfonate), NiO and spiro-OMeTAD (2,2',7,7'-tetrakis-(N,N-di-p-methoxyphenylamine)9,9'-spirobifluorene)), P3HT (poly(3-hexylthiophene-2,5-diyl)). Other known hole transporting materials may also be used in the functional layer.

The presence of the hole transporting material allows to improve performance of photovoltaic devices by facilitating the movement of positive charges generated in the photoactive layer. The hole transporting materials mentioned above are especially suitable for photovoltaic applications as they provide effective hole extraction from perovskite material as well as high hole mobility due to appropriate interfacial energy alignment with the perovskite material. Moreover, an additional technical effect is achieved by combining said hole transporting materials with the phase transfer catalyst, as similarly to the electron transporting material, the phase transfer catalyst supports migration of the reactive ions present therein towards the perovskite material solution disposed on top of the functional layer, which further results in interaction of said ions with perovskite precursors in order to obtain rapid perovskite nucleation, stable perovskite intermediate phase and controlled perovskite crystallization. This leads to fabrication of high-quality perovskite film.

Preferably, the solvent system of the perovskite material solution comprises at least one solvent or combination of solvents selected from the group of alcohols, including monohydric alcohols (methanol, ethanol, isopropanol, n-butanol, ethanol/water azeotropic mixture, etc.), and polyols (ethylene glycol, glycerol etc.), ethers (dibutylether, diethylether etc.), glycol ethers (2-methoxy-ethanol, 1-propoxyethanol etc.), nitriles (acetonitrile, benzonitrile etc.), 2-alkyl-pyrazines (2-ethyl-pyrazine, 2-methyl-pyrazine etc.), chloroform, toluene, chlorobenzene or mixture thereof.

The solvent systems comprising the solvents mentioned above are particularly suitable for applications such as according to the present disclosure. Firstly, they are compatible with perovskite precursors, and allow to obtain good quality photoactive layers. The choice of a proper solvent system to be used for perovskite precursor solutions is especially important, as it will influence perovskite film quality, morphology and ultimately the performance of the solar cell. Secondly, the solvents mentioned above are compatible with the materials present in the underlying functional layer. Namely, they will not damage the solidified charge transporting material, which could lead to unwanted chemical reactions, chemical degradation and overall negatively affect the photovoltaic device performance. Additionally, the abovementioned solvents will not dissolve the phase transfer catalyst, which would limit their ability to provide the desired functionality, as described in the present disclosure.

Preferably, the solvent system of the perovskite material solution comprises an addition of at least one solvent or combination of solvents selected from the group of aprotic polar solvents, including dimethyl sulfoxide (DMSO), dimethylformamide (DMF), N-Methyl-2-pyrrolidone (NMP), gamma-Butyrolactone (GBL) and Dimethylacetamide (DMAC), wherein the amount of the addition is less than 15% of the solvent system. Preferably the amount of the addition in the solvent system is less than 10%. Preferably the amount of the addition in the solvent system is less than 2%.

Aprotic polar solvents, such as DMSO, DMF, NMP, GBL, DMAC are well known, and widely used in perovskite photovoltaic applications. However, they present certain drawbacks when used in large amounts. Aprotic polar solvents selected from DMSO, DMF, NMP, GBL, DMAC used in the fabrication of perovskite solar cells can sometimes be challenging to remove completely from perovskite layers, and the efficient removal of these solvents is crucial for achieving high-quality perovskite films, as residual solvents can lead to defects and reduced performance of the photovoltaic devices. Moreover, the large amount of aprotic polar solvents selected from DMSO, DMF, NMP, GBL, DMAC may influence the drying process of perovskite layers, causing longer drying times and increasing the overall manufacturing time and cost, which can be particularly relevant in the case of mass production. The inventors of the present disclosure have found that the influence of the phase transfer catalyst in the perovskite film formation process allows for the obtaining of compact, uniform and pinhole-free perovskite films with a reduced amount of aprotic polar solvents, such as DMSO, DMF, NMP, GBL, DMAC in the solvent system of the perovskite material solution, addressing all drawbacks mentioned above. Preferably, this reduced amount of said solvents in the solvent system is less than 15%, less than 10% or less than 2%.

Preferably, the functional layer deposition method and the photoactive layer deposition method are independently selected from, but not limited to the group consisting of blade coating, inkjet printing, slot-die coating, gravure printing, spray coating or screen printing.

The aforementioned deposition methods are particularly beneficial in the production of perovskite photovoltaic devices, because they are scalable and therefore compatible with large-scale manufacturing processes. This factor is crucial for commercialization and making perovskite solar technology more widely accessible. They also allow to obtain PV modules at relatively lower cost, as compared to other known methods such as vacuum-based, as they can be performed at lower temperatures and atmospheric pressure, reducing the need for expensive and complex equipment. Moreover, said deposition techniques enable formation of uniform coatings over large-area surfaces, therefore contributing to efficient and stable solar cells. Solution-based techniques, such as the ones mentioned above, can additionally be used in continuous processing, allowing for continuous and efficient production of perovskite solar cells.

In another aspect of the present invention, there is provided a photoactive film obtainable by the method according to the present disclosure. The photoactive film obtainable by the disclosed method is characterized by a reduced amount of pinholes and more uniform surface coverage.

In another aspect of the present invention, there is provided an optoelectronic device comprising the photoactive film obtainable by the method according to the present disclosure. Preferably the optoelectronic device is a solar cell. Solar cells comprising the photoactive films obtainable by the disclosed method are applicable for commercial use, due to their high efficiency, high stability and low production cost.

In yet another aspect of the present invention, there is provided a photoactive film comprising a substrate, a functional layer and a photoactive layer comprising a perovskite material, wherein the photoactive film comprises a phase transfer catalyst.

These and other features, aspects, and advantages of the invention will become better understood with reference to the following drawings, descriptions and claims.

### BRIEF DESCRIPTION OF DRAWINGS

Aspects and features of the present invention will become apparent by describing, in detail, exemplary embodiments of the present invention with reference to the attached drawings, in which:
Fig. 1 shows schematically a structure of the first embodiment of the photoactive film according to the present disclosure;
Fig. 2 shows schematically a structure of the second embodiment of the photoactive film according to the present disclosure;
Fig. 3 shows schematically a structure of the third embodiment of the photoactive film according to the present disclosure;
Fig. 4 shows schematically a structure of the first embodiment of the optoelectronic device comprising the photoactive film according to the present disclosure;
Fig. 5 shows schematically a structure of the second embodiment of the optoelectronic device comprising the photoactive film according to the present disclosure;
Fig. 6 shows schematically the photoactive film formation process with presence of the phase transfer catalyst according to the present disclosure;
Fig. 7 shows schematically the mechanism of the phase transfer catalyst in the photoactive film formation process;
Fig. 8 shows SEM images of the photoactive films obtained by the method according to the present disclosure by using different phase transfer catalysts;
Fig. 9 shows SEM images of the photoactive films obtained by the method according to the present disclosure by using different phase transfer catalysts;
Fig. 10 shows an X-ray diffractogram of the photoactive films obtained by the method according to the present disclosure by using different phase transfer catalysts;
Fig. 11 shows an X-ray diffractogram of the photoactive films obtained by the method according to the present disclosure by using different phase transfer catalysts.

### DETAILED DESCRIPTION OF EMBODIMENTS

Reference will now be made to embodiments, examples of which are illustrated in the accompanying drawings. Aspects and features of the invention will be described with reference to the accompanying drawings. In the drawings, like reference numerals denote like elements. The present invention, however, may be embodied in various different forms and should not be construed as being limited only to the illustrated embodiments. Rather, the presented embodiments are provided as example so that this disclosure will be thorough and complete, and will fully convey the aspects and features of the present invention to those skilled in the art. It shall be understood that not all of the features shown in the embodiment are essential and the scope of the protection is defined not by means of literally shown embodiment, but by the features provided in the claims.

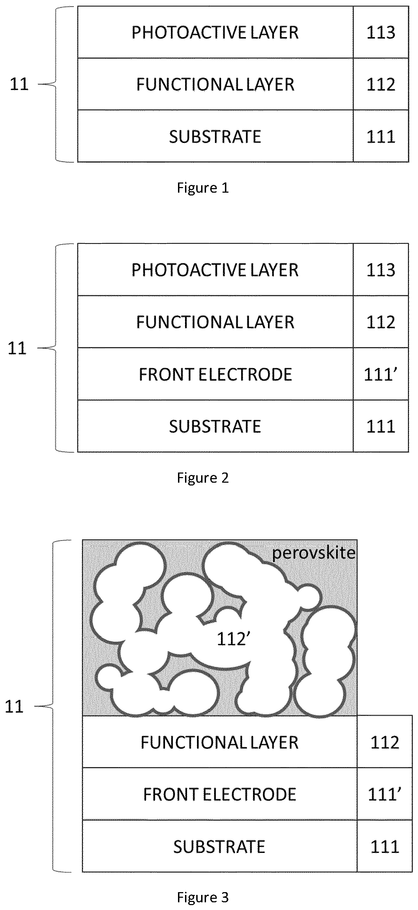

Fig. 1 shows a structure of the first embodiment of the photoactive film 11 according to the present disclosure. The photoactive film 11 according to this embodiment comprises the functional layer 112 disposed between the substrate 111 and the photoactive layer 113. The functional layer 112 is deposited directly on the substrate 111. The functional layer 112 is formed by depositing the functional layer solution directly on the substrate 111. Preferably the functional layer solution comprises the phase transfer catalyst. Preferably, the functional layer solution is composed mainly of a phase transfer catalyst. Preferably, the functional layer solution is composed entirely of a phase transfer catalyst. The photoactive layer 113 is formed by depositing the perovskite material solution comprising A, B and X perovskite precursors and the solvent system onto the functional layer 112. The phase transfer catalyst is selected so as to catalyze the reaction of forming the photoactive layer 113 on the substrate 111, by transferring reactive ions present in the substrate 111 towards the perovskite material solution, where the reactive ions interact with the perovskite precursors. This further enables obtaining a good perovskite film quality with a reduced amount of pin-holes, as the phase transfer catalyst serves function to provide nucleation sites for perovskite crystal growth. The controlled nucleation leads to a more uniform and a high-quality perovskite film. The phase transfer catalyst and/or a cation of the phase transfer catalyst may be contained in the functional layer 112 and/or the photoactive layer 113 after it is formed.

Fig. 2 shows a structure of the second embodiment of the photoactive film 11 according the present disclosure. The photoactive film 11 comprises a substrate 111 comprising a front electrode 111', a functional layer 112 and a photoactive layer 113.

Preferably the substrate 111, according to this embodiment, is made of a flexible and transparent or translucent material selected from the group consisting of, but not limited to: PET (polyethylene terephthalate)), PEN ((poly(ethylene 2,6-naphthalate)), PTFE (poly(ethene-co-tetrafluoroethene)), PMMA (poly(methyl methacrylate)) and PI (polyimide) or a rigid material such as glass. The presence of a deformable substrate 111 can provide elasticity to an optoelectronic device formed on such a substrate.

Preferably the substrate 111 comprises the front electrode 111', which can be made for example of transparent conductive oxide (TCO), made of ITO (indium tin oxide), IZO (indium zinc oxide), FTO (fluorine-doped tin oxide), and/or AZO (aluminum-doped zinc oxide), or an "IMI" structure, comprising at least 2 metal oxide layers with at least one metal layer in between - such as: ITO/Ag/ITO or AZO/Ag/AZO.

The functional layer 112 can be formed by depositing the functional layer solution on the substrate 111. Preferably, the functional layer solution comprises a charge transporting material, such as an electron transporting material or a hole transporting material. The role of the charge transporting material in the functional layer 112 is primarily to facilitate the efficient extraction and transport of charge carriers generated within the photoactive layer 113 due to charge selectivity. Preferably the functional layer solution comprises the phase transfer catalyst, wherein the phase transfer catalyst is selected so as to catalyze the reaction of forming the perovskite material ABX3 in the photoactive layer 113. The functional layer 112 may be formed by a solution processing technique such as spin coating. Other solution process techniques, such as blade coating, inkjet printing or slot die coating may also be used. Forming the functional layer 112 comprises the step of drying the functional layer solution. The drying process is carried out in a temperature below the degradation temperature of the materials present in the functional layer solution, such as the charge transporting material and/or the phase transfer catalyst. The drying temperature may be carried out in a temperature of 120 °C or less. Said temperature range allows to successfully remove solvent residues and to form a solid layer, at the same time making it possible to use flexible substrate materials, which require low-temperature processing. The phase transfer catalyst and/or a cation of the phase transfer catalyst may be contained in the functional layer 112 after forming the photoactive layer 113.

Preferably the photoactive layer 113 comprises perovskite material, preferably the photoactive layer 113 can be entirely made of the perovskite material. The non-limiting examples of the perovskite materials for the photoactive layer 113 are selected from the group consisting of 3D, 2D, and quasi-2D perovskite, for example: 3D perovskites of general formula: ABX3 wherein A denotes methylammonium, formamidinium, caesium or mixture thereof, B denotes Pb, Sn or mixture thereof, X denotes iodine, bromine, fluorine or mixture thereof; 2D perovskite of general formula A'2BX4 wherein A' denotes large alkylammonium cation (e.g. butylammonium, phenethylammonium or 4-fluorophenethylammonium, etc.), B denotes Pb, Sn or mixture thereof, X denotes iodine, bromine, fluorine or mixture thereof; or mixture of 2D and 3D perovskites, called also quasi-2D perovskites of general formula A'2An-1PbnX3n+1, wherein A' denotes large alkylammonium cation such as e.g. butylammonium, phenethylammonium, or 4-fluorophenethylammonium, etc., A denotes methylammonium, formamidinium, caesium or mixture thereof, B denotes Pb, Sn or mixture thereof, X denotes iodine, bromine, fluorine or mixture thereof; in the above formulas n typically can equal 3-6. The photoactive layer 113 may be formed by a solution processing technique such as spin coating (other solution process technique, such as blade coating, inkjet printing or slot die coating may also be used). Forming the photoactive layer 113 of perovskite material further comprises the step of annealing the perovskite material solution. The annealing step allows increase crystallinity and grain size of the photoactive layer, as well as remove potentially remaining defects. Preferably the perovskite annealing step is carried out in a temperature allowing to use flexible substrate materials, which usually require low-temperature processing. Preferably the annealing temperature is equal to or lower than 120 °C. The phase transfer catalyst and/or a cation of the phase transfer catalyst may be contained in the photoactive layer 113 after its formation. The obtained photoactive film 11 is characterized by reduced amount of pinholes, high uniformity and high quality.

Fig. 3 shows a structure of the third embodiment of the photoactive film 11 according to the present disclosure. The photoactive film 11 according to this embodiment comprises a functional layer 112, wherein the functional layer 112 comprises a mesoporous scaffold 112' formed on the side of the functional layer 112 facing away from the substrate 111. The mesoporous scaffold 112' is designed, so that the photoactive material, preferably perovskite material fills the pores of the scaffold 112'. The mesoporous scaffold 112' is formed by depositing a scaffold solution on the side of the functional layer 112 facing away from the substrate 111. The photoactive material is obtained by filling the pores present in the mesoporous scaffold 112' with the perovskite material solution comprising A, B and X perovskite precursors and the solvent system.

The mesoporous scaffold 112' preferably comprises a charge transporting material selected from electron transporting materials or hole transporting materials, as it is described earlier in this disclosure. The structure of the mesoporous scaffold 112' comprising the charge transporting material provides a high contact surface area between the charge transporting material and the perovskite material, which enhances charge extraction of the photoexcited charges.

The mesoporous scaffold 112' preferably comprises a dielectric material. The structure of the mesoporous scaffold 112' comprising the dielectric material provides limited electron-hole recombination in the photoactive film 11 or in an optoelectronic device comprising such photoactive film 11. It separates the charge transporting material contained in the functional layer 112 from either an opposite charge transporting layer, which opposite charge transporting layer may be present in an optoelectronic device and/or a counter electrode which counter electrode may be deposited on the other side of the photoactive film 11 to form an optoelectronic device. Also, the mesoporous scaffold 112' comprising the dielectric material prevents charges (e.g. electrons) present in the charge transporting material present in the functional layer 112 to recombine with opposite charges (e.g. holes) present in the photoactive layer 113. Therefore the generated charges can move efficiently towards the respective electrodes. The dielectric material contained in the mesoporous scaffold 112' is preferably selected from the group consisting of: Cr2O3, ZrO2, Al2O3. Said materials are particularly suitable to work as dielectric materials in the porous dielectric scaffold according to the present disclosure, since they posses insulating properties, due to their high bandgap.

The mesoporous scaffold 112' preferably comprises the phase transfer catalyst, where the phase transfer catalyst is selected so as to catalyze the reaction of forming the photoactive material ABX3 from A, B and X perovskite precursors by transferring the reactive ions present in the mesoporous scaffold 112' towards the perovskite material solution, where these reactive ions interact with the perovskite precursors. The phase transfer catalyst and/or a cation of the phase transfer catalyst may be contained in the mesoporous scaffold 112' together with the charge transporting material. The phase transfer catalyst and/or a cation of the phase transfer catalyst may be contained in the mesoporous scaffold 112' together with the dielectric material. The function of the phase transfer catalyst enables to obtain a good perovskite film quality, as it provides nucleation sites on the mesoporous scaffold 112' for uniform perovskite crystal growth. The controlled nucleation leads to rapid perovskite nucleation and as a result allows to form more uniform and high quality perovskite films, as it was described more in details earlier in this disclosure. After the photoactive material is formed the phase transfer catalyst and/or a cation of the phase transfer catalyst may be contained in either the mesoporous scaffold 112', in the photoactive material or at the interface between the mesoporous scaffold 112' and the photoactive material.

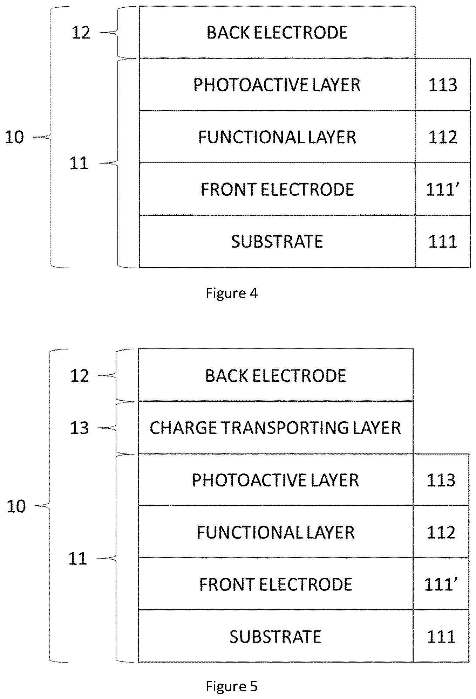

Fig. 4 shows a structure of the first embodiment of the optoelectronic device 10 comprising the photoactive film 11 according to the present disclosure. The optoelectronic device 10 comprises the back electrode 12 deposited on the photoactive film 11. The back electrode 12 may be made of at least one metal or carbon material. Preferably the back electrode 12 is made of carbon. Preferably the optoelectronic device 10 is a photovoltaic device. The photovoltaic device comprising the photoactive film 11 is characterized by high efficiency, high stability and low production cost, making it more applicable for commercial use.

Fig. 5 shows a structure of the second embodiment of the optoelectronic device 10 comprising the photoactive film 11 according to the present disclosure. The optoelectronic device 10 comprises the charge transporting layer 13 deposited between the photoactive film 11 and the back electrode 12. The charge transporting layer 13 may comprise either electron transporting material or hole transporting material, depending on the architecture of the optoelectronic device 10. In case the functional layer 112 comprises electron transporting material, the charge transporting layer 13 may comprise hole transporting material. In case the functional layer 112 comprises hole transporting material, the charge transporting layer 13 may comprise electron transporting material. The charge transporting layer 13 serves function to facilitate the efficient transport and collection of charges generated in the photoactive film 11, which leads to increased performance of the optoelectronic device 10.

The optoelectronic device 10 comprising the photoactive film 11 according to this disclosure may find variety of applications, such as in portable electronic devices, building-integrated photovoltaics (BIPV), solar-powered vehicle applications or in IoT (Internet of things), due to its advantages as it was described before.

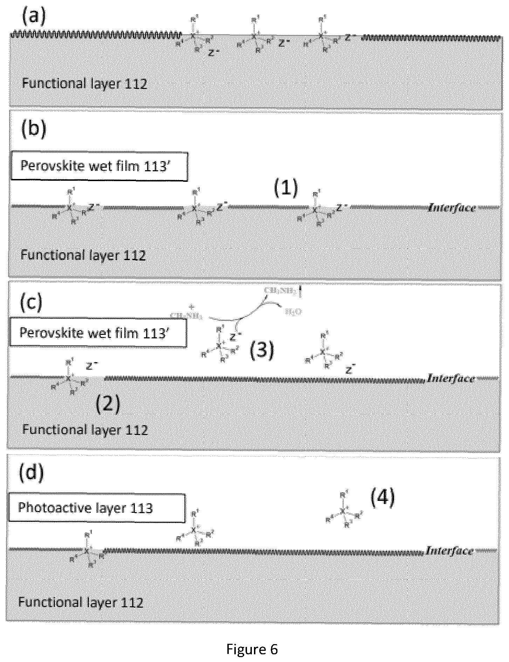

Fig. 6 shows schematically a formation process of the photoactive layer 113 with presence of the phase transfer catalyst according to the present disclosure. Fig. 6(a) shows the first stage of the photoactive layer 113 formation process in which the functional layer 112 comprises the phase transfer catalyst accumulated on the top surface of the functional layer 112. Fig. 6(b) shows the second stage of forming the photoactive layer 113 according to the present disclosure, in which the perovskite wet film 113' containing perovskite material solution which comprises A, B and X perovskite precursors and the solvent system is deposited on top of the functional layer 112 and in which the phase transfer catalyst is oriented at the interface between the functional layer 112 and the perovskite wet film 113'. Fig. 6(c) shows the third stage of forming the photoactive layer 113 according to the present disclosure, in which the phase transfer catalyst serves function to migrate reactive ions present in the functional layer 112 towards the perovskite wet film 113'. The reactive ions may be present in the charge transporting material comprised in the functional layer 112. The reactive ions may be negatively charged ions, such as OH- anions. The reactive ions interact with perovskite precursors contained in the perovskite wet film 113'. This interaction provides enhanced perovskite nucleation rate, enabling bottom-to-top perovskite crystals growth. This further results in obtaining a stable perovskite intermediate phase and therefore a wider processing window for the consecutive formation of the photovoltaic device. Fig. 6(d) shows the final stage of forming the photoactive layer 113, in which the interaction of the reactive ions with the perovskite precursors is terminated. The phase transfer catalyst and/or a cation of the phase transfer catalyst may be contained in the photoactive layer 113 after it is formed. The phase transfer catalyst and/or a cation of the phase transfer catalyst may be contained in the functional layer 112 after the photoactive layer 113 is formed. The phase transfer catalyst and/or a cation of the phase transfer catalyst may be contained at the interface between the functional layer 112 and the photoactive layer 113, after the photoactive layer 113 is formed.

It should be noted, that the mechanism of forming the photoactive layer 113 as depicted in Fig. 6 applies in analogous manner to the embodiment of the present disclosure in which the perovskite wet film comprising the perovskite material solution is deposited in the pores of the mesoporous scaffold 112' of the functional layer 112, as shown in Fig. 3. In this embodiment, the phase transfer catalyst may be comprised in the mesoporous scaffold 112', along with a charge transporting material or along with a dielectric material. The reactive ions present in the mesoporous scaffold 112' interact with the perovskite precursors present in the perovskite material solution, due to the function of the phase transfer catalyst, as it is described above. This results in improved nucleation rate and allows to obtain more uniform perovskite crystals, and therefore a more uniform and better quality photoactive layer 113.

It should also be noted, that the mechanism of forming the photoactive layer 113 as depicted in Fig. 6 applies in an analogous manner to the embodiment of the present disclosure in which the functional layer 112, deposited directly on the substrate 111, is made mainly of a phase transfer catalyst or in which the functional layer 112 is made entirely of a phase transfer catalyst, as shown in Fig. 1. The reactive ions present in the substrate 111 interact with the perovskite precursors present in the perovskite material solution, due to the function of the phase transfer catalyst, as it is described above. The photoactive layer 113 with enhanced film quality and superior uniformity may be grown directly on the substrate 111.

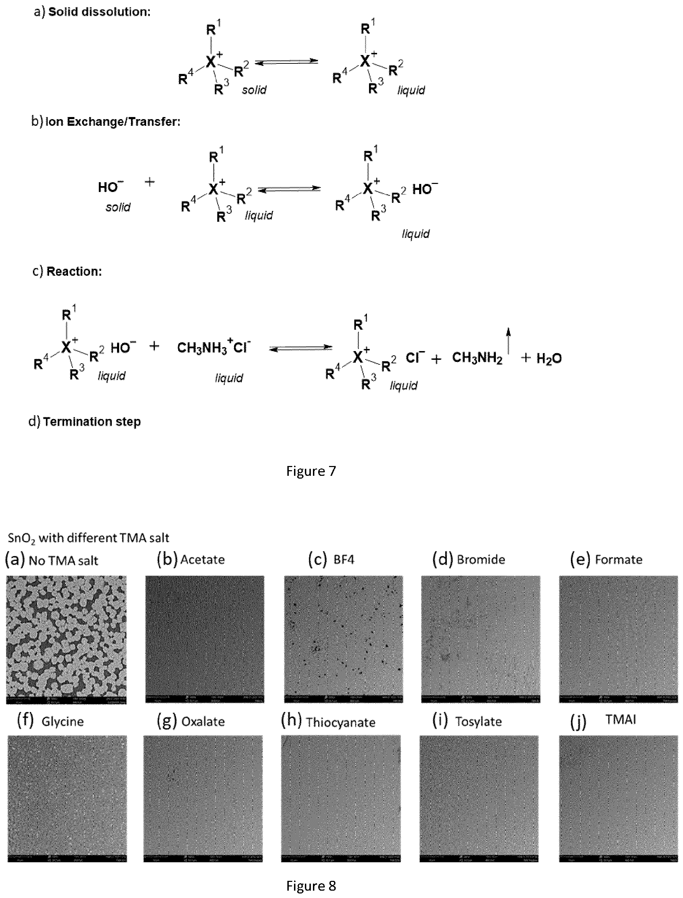

Fig. 7 shows the mechanism of the phase transfer catalyst in formation process of the photoactive layer 113 according to the present disclosure. Fig. 7(a) shows a stage of forming the photoactive layer 113, in which the phase transfer catalyst is dissolved from a solid state to a liquid state. Fig. 7(b) shows a stage of forming the photoactive layer 113, in which the phase transfer catalyst forms a complex with a reactive ion. Fig. 7(c) shows a stage of forming the photoactive layer 113, in which the phase transfer catalyst transfers the reactive ion to the perovskite phase to interact with a perovskite precursor. Fig. 7(d) shows a stage of forming the photoactive layer 113, in which the transfer and interaction of the reactive ions with perovskite precursors is terminated and the photoactive layer 113 is formed.

Fig. 8 shows SEM images of the photoactive films obtained by different methods. Fig. 8(a) shows for reference a photoactive film obtained by forming the photoactive layer without the presence of the phase transfer catalyst. Figs. 8(b) - (j) show SEM images of the photoactive films obtained by the method according to the present disclosure by using different phase transfer catalysts. Figs. 8(b) - (j) show improved photoactive film quality with reduced amount of pinholes and better uniformity as compared to the photoactive film obtained by a method not according to the present disclosure.

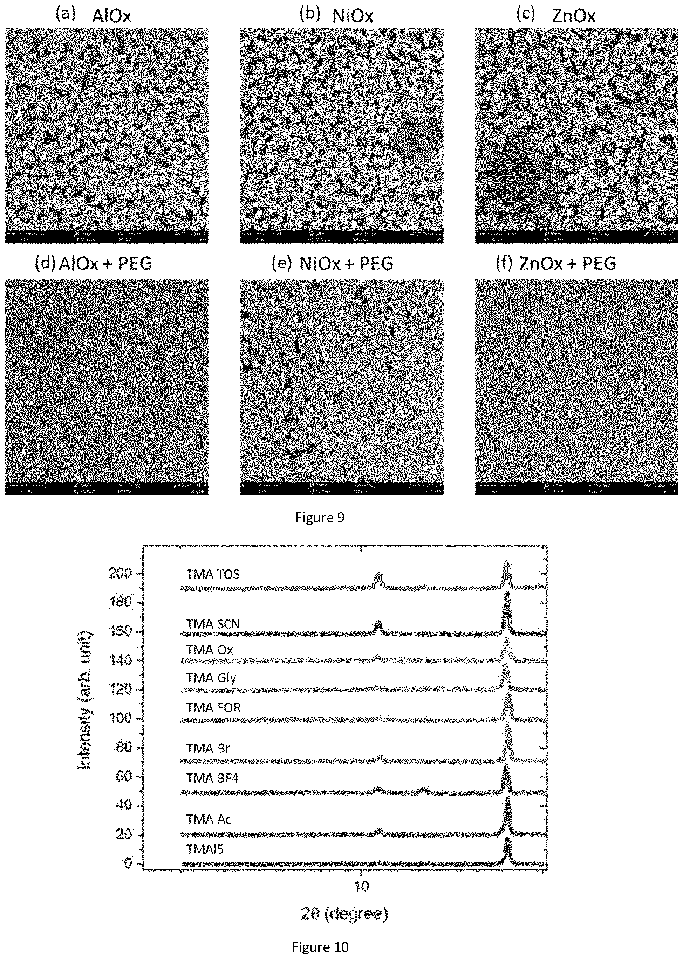

Fig. 9 shows SEM images of the photoactive films obtained by different methods. Figs. 9(a) - (c) show for reference the photoactive films obtained by forming the photoactive layer without the presence of the phase transfer catalysts. Figs. 9(d) - (f) show SEM images of the photoactive films obtained according to the present disclosure by using different phase transfer catalysts. Figs. 9(d) - (f) show improved photoactive film quality with a reduced amount of pinholes and better uniformity as compared to the photoactive film obtained not according to the present disclosure.

Fig. 10 shows XRD spectra of the photoactive films grown using the method according to the present disclosure, by using different TMA salts as phase transfer catalysts. As it can be seen from Fig. 10, the photoactive films show clear perovskite 110 peaks. Additional peaks, which are left-shifted with reference to 110 peaks are also present in the XRD spectra. These additional peaks may relate to the formation of low-dimensional perovskite structures. Low-dimensional perovskites, such as 2D perovskites demonstrate improved stability as compared to 3D perovskites. This enhanced stability can extend the lifespan of optoelectronic devices containing 2D perovskites. Formation of 2D perovskite may also lead to creating hybrid 2D/3D perovskite structures. In such structures the 2D perovskites provide additional advantages, such as improved charge carrier extraction, enhanced moisture resistance and a reduced amount of defects in the lattice of the 3D perovskite, by defect passivation.

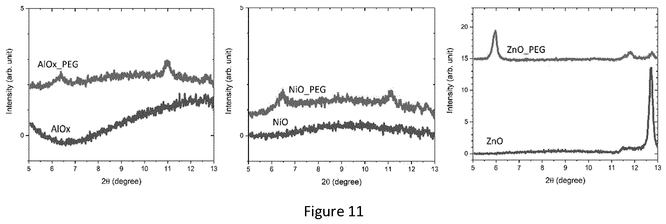

Fig. 11 shows XRD spectra of the photoactive films grown using the method according to the present disclosure, by using PEG additives as phase transfer catalyst. As it can be seen from Fig. 11, the photoactive films show an evident left-shift in the XRD spectra in embodiments where the phase transfer catalysts were used in the photoactive film formation process according to the method of the present disclosure, as compared to the XRD spectra of the photoactive films formed without the presence of the phase transfer catalysts. The left-shifted peaks may relate to the creation of 2D perovskite structures, which leads to advantages as described in the paragraph above.

### Example 1 - preparation of a photoactive film having a perovskite photoactive layer directly on a substrate (as shown in Fig. 1)

Glass substrate is cleaned and activated using plasma activation for a subsequent layer deposition (dry cleaning, wet cleaning, or UV-O3 activation may also be used). A functional layer is prepared by depositing a functional layer solution, prepared by providing ZnO aqueous dispersion having TMACl with concentration of 100 mg/mL. The functional layer of thickness between 50-150 nm is obtained. A photoactive layer is prepared by depositing a perovskite material solution of FAI, MACl and PbI2 (1:0.4:1.1) dissolved in a solvent system of 2-methoxyethanol and DMSO (1:0.02) on the functional layer by spin coating (other solution process techniques, such as blade coating, inkjet printing or slot die coating may also be used). The layer is crystallized on the hot plate or in the oven for around 20 min at 120 °C. The photoactive layer of thickness between 200-1000 nm is obtained. The thicknesses of the functional layer and the thickness of the photoactive layer depends on deposition parameters.

### Example 2 - preparation of a photoactive film having a perovskite photoactive layer and a functional layer solution comprising tin oxide + PTC (quaternary salt)

The PET substrate coated with an FTO conductive material (another materials, such as ITO, AZO, IZO may also be used) is cleaned and activated using plasma activation for a subsequent layer deposition (dry cleaning, wet cleaning, or UV-O3 activation may also be used). A functional layer is prepared by depositing a functional layer solution, prepared by providing SnO₂ aqueous dispersion (5 wt%) having TMAOH with concentration of 0.5 mg/mL by a solution processing technique such as spin coating (other solution process technique, such as blade coating, inkjet printing or slot die coating may also be used). After deposition sample is dried on the hot plate or in the oven at 100 °C for 20 minutes. The functional layer of thickness between50-150 nm is obtained. A photoactive layer is prepared by depositing a perovskite material solution of FAI, MACl and PbI₂ (1:0.4:1.1) dissolved in a solvent system of 2-methoxyethanol and DMSO (1:0.02) on the functional layer by spin coating (other solution process techniques, such as blade coating, inkjet printing or slot die coating may also be used). The layer is crystallized on the hot plate or in the oven for around 20 min at 120 °C. The photoactive layer of thickness between 200-1000 nm is obtained. The thicknesses of the functional layer and the thickness of the photoactive layer depends on deposition parameters.

### Example 3 - preparation of a photoactive film having a perovskite photoactive layer and a functional layer solution comprising tin oxide + PTC (PEG) XXX

A substrate is prepared according to Example 1. A functional layer is prepared by depositing a functional layer solution, prepared by providing ZnO aqueous dispersion having PEG 20000 additive with concentration of 10 mg/mL by a solution processing technique such as spin coating (other solution process technique, such as blade coating, inkjet printing or slot die coating may also be used). After deposition sample is dried on the hot plate or in the oven at 100 °C for 20 minutes. The functional layer of thickness between 50-150 nm is obtained. The thickness of the functional layer may vary and it depends on deposition parameters, and solution concentration. Next the photoactive layer is prepared according to Example 2.

### Example 4 - preparation of a solar cell containing a photoactive film according to Example 2 or Example 3

The photoactive film is prepared according to any of the Examples 2 or 3. Next a carbon electrode is prepared by depositing a carbon paste onto the photoactive film using rod-coating technique or screen printing. After deposition, the layer is dried using IR lamp for 3 minutes. Carbon electrode of the thickness 30 µm was obtained.

## Claims

1. A method for producing a photoactive film (11) comprising a substrate (111), a photoactive layer (113) with a perovskite material and a functional layer (112) between the substrate (111) and the photoactive layer (113), **characterized in that** the method comprises:
- forming the functional layer (112) by depositing a functional layer solution on the substrate (111);
- forming the photoactive layer (113) of perovskite material ABX3 by depositing a perovskite material solution on the functional layer (112);
- wherein the perovskite material solution comprises A, B and X perovskite precursors, and a solvent system;
- and wherein the functional layer solution comprises a phase transfer catalyst, wherein the phase transfer catalyst is selected so as to catalyze the reaction of forming ABX3 from A, B and X perovskite precursors.

2. The method according to claim 1, wherein the phase transfer catalyst is selected from the group of quaternary salts with a general formula: 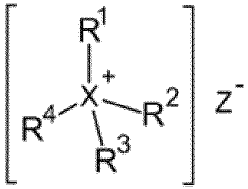 wherein
R¹, R², R³, R⁴ each independently represents an alkyl group, a hetero alkyl group, an aryl group, a hetero aryl group, an alkylaryl group, a hetero alkylaryl group, wherein heteroatoms comprise at least one of N, O, S;
X represents nitrogen or phosphorous;
Z represents
an inorganic anion selected from the group of halides, triflates, hydroxide (OH⁻), nitrate (NO₃⁻), sulfate (SO₄²⁻), phosphate (PO₄³⁻), carbonate (CO₃²⁻), bicarbonate (HCO₃⁻), peroxide (O₂²⁻), cyanide (CN⁻), thiocyanate (SCN⁻), sulfite (SO₃²⁻), thiosulfate (S₂O₃²⁻), hypochlorite (ClO⁻), chlorate (ClO₃⁻), perchlorate (ClO₄⁻), permanganate (MnO₄⁻), chromate (CrO₄²⁻), dichromate (Cr_2O₇²⁻), azide (N₃⁻), hydrogensulfate (HSO₄⁻), hydrogenphosphate (HPO₄²⁻), dihydrogenphosphate (H₂PO₄⁻), or
an organic anion selected from the group of carboxylates (C₁ - Cs) including dicarboxylates (C₂ - C₆), benzoate (C₆H₅COO⁻) or lactate (C₃H₅O₃⁻);
or the group of polyether materials comprising: PEG materials having molecular weights in the range of 400 g/mol to 2000000 g/mol, which corresponds to PEG 400 and PEG 2000000 respectively.

3. The method according to any of the preceding claims, wherein the solution comprises the phase transfer catalyst in a concentration between 0.1 mg/mL and 100 mg/mL.

4. The method according to any of the preceding claims, wherein the functional layer solution comprises a charge transporting material.

5. The method according to claim 4, wherein the charge transporting material is an electron transporting material selected from the group consisting of SrO2, SnO2, TiO2, ZnO, ZnSnO4, ZnSnS4, BaSnO4 and PCBM.

6. The method according to any of the claim 4, wherein the charge transporting material is a hole transporting material selected from the group consisting of: CuSCN, CuO, Cu2O, CuI, CuBr, WO3, MoO3, CoO, CoO2, PTAA (Poly[bis(4-phenyl)(2,4,6-trimethylphenyl)amine), PEDOT:PSS (poly(3,4-ethylenedioxythiophene) polystyrene sulfonate), NiO and spiro-OMeTAD (2,2',7,7'-tetrakis-(N,N-di-p-methoxyphenylamine)9,9'-spirobifluorene)), P3HT (poly(3-hexylthiophene-2,5-diyl)).

7. The method according to any of the preceding claims, wherein the solvent system of the perovskite material solution comprises at least one solvent selected from the group consisting of 2-alkyl-pyrazines (2-ethyl-pyrazine, 2-methyl-pyrazine etc.), nitriles (acetonitrile, benzonitrile etc.), alcohols (methanol, ethanol, isopropanol etc.) glycol ethers (2-methoxy-ethanol, 1-propoxyethanol etc.), ethers (dibutylether, diethylether etc.), toluene, chlorobenzene or water.

8. The method according to claim 7, wherein the solvent system of the perovskite material solution comprises an addition of at least one solvent selected from the group consisting of dimethyl sulfoxide (DMSO), dimethylformamide (DMF), N-Methyl-2-pyrrolidone (NMP), gamma-Butyrolactone (GBL), Dimethylacetamide (DMAC), wherein the amount of the addition in the solvent system is less than 15%.

9. The method according to any of the preceding claims, wherein the functional layer deposition method and the photoactive layer deposition method are independently selected from the group consisting of: spin coating, blade coating, inkjet printing, slot die coating.

10. The method according to any of the preceding claims, comprising forming the functional layer (112) by depositing a functional layer solution on the substrate (111) material.

11. The method according to any of claims 1-9, comprising forming the functional layer (112) by depositing a functional layer solution on a front electrode (111') comprised in the substrate (111).

12. A photoactive film (11) produced by the method according to any of previous claims.

13. An optoelectronic device (10) comprising the photoactive film (11) according to claim 12.

14. The optoelectronic device (10) according to claim 13, wherein the optoelectronic device is a photovoltaic cell.

15. A photoactive film (11) comprising a substrate (111), a photoactive layer (113) with a perovskite material and a functional layer (112) between the substrate (111) and the photoactive layer (113), **characterized in that** the photoactive film (11) comprises a phase transfer catalyst in at least one of the functional layer (112) and the photoactive layer (113).
